# EUROPEAN PATENT APPLICATION

(11) **EP 3 229 266 A1**
(43) Date of publication of application: **11.10.2017**
(21) Application number: 15872392.4
(22) Date of filing: 28.09.2015
(51) Int. Cl.: H01L 21/56

(54) **RESIN MOLDING DEVICE AND RESIN MOLDING METHOD**

(30) Priority: 24.12.2014 JP 2014261098
(71) Applicant: Towa Corporation, Kyoto-shi, Kyoto 601-8105 (JP)
(72) Inventor: TAKA, Takeaki, Kyoto-shi Kyoto 601-8105 (JP)
(74) Representative: Prüfer & Partner mbB Patentanwälte · Rechtsanwälte
(86) International application number: PCT/JP2015/077300
(87) International publication number: WO 2016/103823

(57) **Abstract**

In a resin molding device (1), a lower mold (4) includes a side surface member (8), and a bottom surface member (9) which can be moved up and down inside the side surface member (8). Substrate pressing pins (17) are provided in the bottom surface member (9). A substrate (6) having a through hole and a connection electrode portion formed therein is fixed to an upper mold (3). The lower mold (4) is moved up to bring tip portions of the substrate pressing pins (17) into close contact with predetermined regions where the through hole and the connection electrode portion are formed, and press the predetermined regions. By moving up the lower mold (4), the substrate (6) is clamped by an upper surface of the side surface member (8), and the predetermined regions are further pressed by the substrate pressing pins (17). Since the substrate pressing pins (17) press the periphery of the through hole and the surface of the connection electrode portion, it is possible to prevent a fluid resin from entering the periphery of the through hole and the surface of the connection electrode portion. Therefore, the surface-exposed state before resin sealing is performed can be maintained, with no sealing resin being formed at the predetermined regions.

## Description

### TECHNICAL FIELD

The present invention relates to a resin molding device and a resin molding method used for example when sealing a chip-shaped electronic component (hereinafter appropriately referred to as a "chip"), such as a transistor, an integrated circuit (IC), or a light emitting diode (LED), with resin.

### BACKGROUND ART

Sealing an electronic component such as an IC mounted on a circuit substrate such as a lead frame, a printed circuit substrate, or a ceramic substrate with a cured resin has been conventionally performed using a resin molding technique such as a transfer molding method, a compression molding method, or an injection molding method. In recent years, resin sealing using the compression molding method has been increasingly required in accordance with the trend toward larger and thinner circuit substrates, circuit substrates stacked by three-dimensional packaging, and the like. In the document of the present application, a circuit substrate will be appropriately referred to as a "substrate".

Resin sealing by the compression molding method is performed as follows. In a resin molding device, a granular resin is supplied into a cavity provided in a lower mold, and is heated and melted to produce a molten resin (fluid resin). Then, an upper mold and the lower mold are closed, and a semiconductor chip mounted on a substrate is immersed in the fluid resin. A cavity bottom surface member applies a predetermined resin pressure onto the fluid resin to cure the fluid resin and form a cured resin. Thereby, the semiconductor chip mounted on the substrate is sealed with the cured resin.

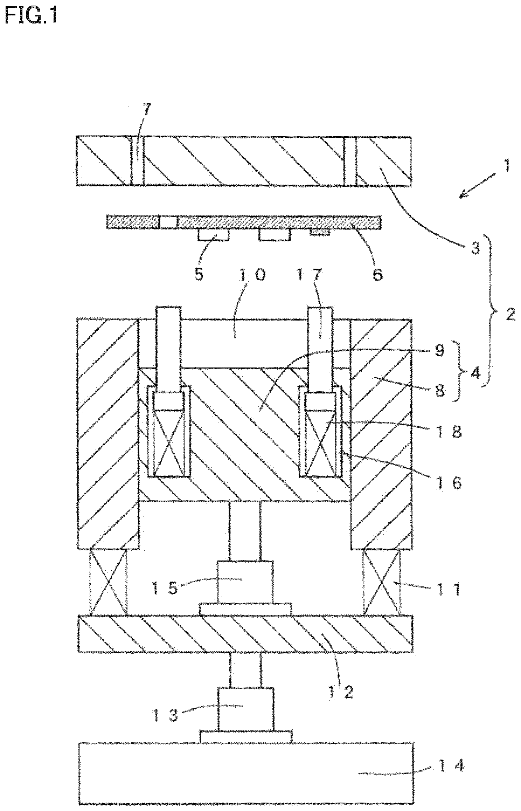

A three-dimensionally packaged semiconductor device, which is called a PoP (Package on Package) type semiconductor device, is used in a mobile phone, a digital camera, and the like. In the three-dimensional packaging technique, in order to stack a substrate having a semiconductor chip mounted thereon, it is necessary to form later an exposed portion (opening) where no sealing resin is formed, at a portion of the substrate, for example, at a connection electrode portion such as a pad. A method of forming an opening leading to a pad by irradiating a sealing resin with a laser beam has been proposed (see, for example, PTD 1, paragraph [0008] and Fig. 1). Substrates are stacked by connecting a connection electrode portion provided at the exposed portion with a connection electrode portion provided in another substrate via a projection electrode. By stacking the substrates, the degree of freedom of wiring can be increased and wiring resistance can be decreased. In addition, by stacking the substrates, the packaging area of a product can be decreased. Accordingly, a high-performance, highly integrated semiconductor device can be implemented. In order to meet such a demand, there has been a need for a resin molding device which can perform resin sealing with a portion of a substrate being exposed.

As a method of compression-molding a semiconductor chip, there has been proposed a compression molding method described as "a method of compression-molding a semiconductor chip ..., comprising: disposing a required number of connection electrodes around the semiconductor chip ...; covering the mold cavity with a mold release film having a required thickness; supplying a required amount of resin material into the mold cavity covered with the mold release film, and heating and melting the resin material...; immersing the semiconductor chip and the connection electrodes therearound in the heated and melted resin material...; pressurizing the heated and melted resin material... by a cavity bottom surface member provided at a bottom surface of the mold cavity, and compression-molding the resin material; and pressing the connection electrodes against the mold release film when pressurizing the resin material in the mold cavity" (see, for example, PTD 2, paragraph [0014] and Figs. 1 to 5).

### CITATION LIST

### PATENT DOCUMENT

PTD 1: Japanese Patent Laying-Open No. 2013-12522
PTD 2: Japanese Patent Laying-Open No. 2009-181970

### SUMMARY OF INVENTION

### TECHNICAL PROBLEM

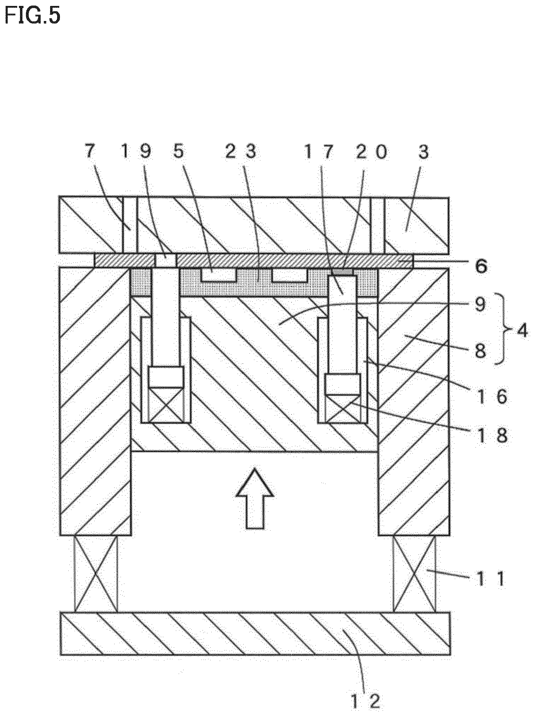

However, the compression molding method disclosed in PTD 2 has a problem as described below. As shown in Figs. 1 and 5 of PTD 2, a lower mold cavity (collective large cavity) 10 includes a semiconductor chip corresponding portion (medium cavity) 15 corresponding to a semiconductor chip 2, and a connection electrode corresponding portion (small cavity) 16 corresponding to connection electrodes 5 for stacking. In lower mold cavity (depression) 10, the depth of semiconductor chip corresponding portion (depression) 15 is formed to be relatively deep, and the depth of connection electrode corresponding portion (depression) 16 is formed to be relatively shallow.

A molded substrate 18 is obtained by collectively compression-molding the semiconductor chip and connection electrodes 5 therearound within a collective resin portion 17 corresponding to the shape of lower mold cavity (collective cavity) 10. On this occasion, by pressing tip portions 5a of connection electrodes 5 by a mold release film 13 covering a bottom surface 16a of connection electrode corresponding portion 16, tip portions 5a of connection electrodes 5 are embedded in mold release film 13. Accordingly, the connection electrodes can be molded with tip portions 5a thereof being exposed from collective resin portion 17, without immersing tip portions 5a of connection electrodes 5 in a heated and melted resin material 14.

In such a compression molding device, semiconductor chip corresponding portion 15 and connection electrode corresponding portion 16 are clearly separated in lower mold cavity 10. Therefore, in designing a product, there is imposed a restriction that a region which will serve as the semiconductor chip and a region where the connection electrodes will be formed should be designed to be completely separated. In addition, since the semiconductor chip corresponding portion and the connection electrode corresponding portion are separated by using the mold release film, it is necessary to change the mold release film for each molding, which leads to higher product cost.

The present invention has been made to solve the aforementioned problem, and an object of the present invention is to provide a resin molding device and a resin molding method capable of performing resin sealing with an exposed portion being provided at a predetermined region of a substrate, by using a simple mold for compression molding in the resin molding device, without using a mold release film.

### SOLUTION TO PROBLEM

In order to solve the aforementioned problem, a resin molding device in accordance with the present invention is a resin molding device including: an upper mold; a lower mold provided to face the upper mold; a frame member provided at least in the lower mold; a bottom surface member which is provided at least in the lower mold, and can be relatively moved up and down with respect to the frame member inside the frame member; a cavity constituted of a space surrounded by the frame member and the bottom surface member; a resin material supply mechanism which supplies a resin material into the cavity; a substrate transport mechanism which transports a substrate having an electronic component mounted on a main surface thereof to a space between the lower mold and the upper mold; a first drive mechanism which moves up and down the frame member; and a second drive mechanism which moves up and down the bottom surface member, characterized in that the resin molding device includes a substrate pressing member provided in the frame member or the bottom surface member and a tip portion provided in the substrate pressing member, the tip portion of the substrate pressing member is brought into close contact with a predetermined region provided in the main surface of the substrate and presses the predetermined region by moving up the substrate pressing member using the first drive mechanism or the second drive mechanism, and, in a state where the upper mold and the lower mold are closed by moving up the frame member and the bottom surface member, the electronic component is immersed in a fluid resin produced from the resin material in the cavity, and the electronic component is sealed with a cured resin formed by curing the fluid resin, with the predetermined region being exposed from the cured resin.

Further, the resin molding device in accordance with the present invention is characterized in that, in the resin molding device described above, in a state where the upper mold and the lower mold are opened, the tip portion of the substrate pressing member is formed to be higher than an upper surface of the frame member.

Further, the resin molding device in accordance with the present invention is characterized in that the resin molding device described above includes an elastic body supporting the substrate pressing member.

Further, the resin molding device in accordance with the present invention is characterized in that the resin molding device described above includes one or a plurality of the substrate pressing members, an attachment plate having the one or plurality of the substrate pressing members attached thereto, and one or a plurality of elastic bodies supporting the attachment plate.

Further, the resin molding device in accordance with the present invention is characterized in that, in the resin molding device described above, the tip portion of the substrate pressing member has a tapered portion, and the tip portion including the tapered portion blocks a hole provided at the predetermined region to prevent the fluid resin from entering the hole.

Further, the resin molding device in accordance with the present invention is characterized in that, in the resin molding device described above, the tip portion of the substrate pressing member has a tip surface, and the tip surface comes into close contact with the predetermined region of the substrate to prevent the fluid resin from entering the predetermined region.

Further, the resin molding device in accordance with the present invention is characterized in that the resin molding device described above includes at least one molding module which has a mold closing mechanism for closing the upper mold and the lower mold, and a resin material supply module which supplies the resin material to the one molding module, and the resin material supply module is attachable to and detachable from the one molding module, and the one molding module is attachable to and detachable from another molding module.

In order to solve the aforementioned problem, a resin molding method in accordance with the present invention is a resin molding method including: arranging a substrate having an electronic component mounted on a main surface thereof between an upper mold and a lower mold facing the upper mold; supplying a resin material into a cavity constituted of a space surrounded by a frame member and a bottom surface member which are included at least in the lower mold; moving up and down the frame member by a first drive mechanism; and moving up and down the bottom surface member inside the frame member by a second drive mechanism, characterized in that the resin molding method includes: moving up a substrate pressing member provided in the frame member or the bottom surface member; bringing a tip portion of the substrate pressing member into close contact with a predetermined region of the substrate and pressing the predetermined region; moving up the frame member and thereby pressing a peripheral edge portion of the substrate by the frame member; producing a fluid resin from the resin material within the cavity; moving up the bottom surface member and immersing the electronic component in the fluid resin; and curing the fluid resin to form a cured resin, and the electronic component is sealed with the cured resin cured at a region other than the predetermined region in the main surface of the substrate.

Further, the resin molding method in accordance with the present invention is characterized in that, in the supplying the resin material in the resin molding method described above, the tip portion of the substrate pressing member is located higher than an upper surface of the frame member.

Further, the resin molding method in accordance with the present invention is characterized in that, in the pressing in the resin molding method described above, the substrate pressing member supported by an elastic body is used.

Further, the resin molding method in accordance with the present invention is characterized in that, in the pressing in the resin molding method described above, one or a plurality of the substrate pressing members attached to an attachment plate supported by one or a plurality of elastic bodies are used.

Further, the resin molding method in accordance with the present invention is characterized in that, in the resin molding method described above, the tip portion of the substrate pressing member has a tapered portion, and in the pressing, the tip portion including the tapered portion is used to block a hole provided at the predetermined region to prevent the fluid resin from entering the hole.

Further, the resin molding method in accordance with the present invention is characterized in that, in the resin molding method described above, the tip portion of the substrate pressing member has a tip surface, and in the pressing, the tip surface is brought into close contact with the predetermined region to prevent the fluid resin from entering the predetermined region.

Further, the resin molding method in accordance with the present invention is characterized in that the resin molding method described above includes preparing at least one molding module which has a mold closing mechanism for closing the upper mold and the lower mold, and preparing a resin material supply module which supplies the resin material to the one molding module, and the resin material supply module is attachable to and detachable from the one molding module, and the one molding module is attachable to and detachable from another molding module.

### ADVANTAGEOUS EFFECTS OF INVENTION

According to the present invention, a resin molding device includes: an upper mold; a lower mold provided to face the upper mold; a frame member provided in the lower mold; a bottom surface member which is provided in the lower mold and can be relatively moved up and down with respect to the frame member inside the frame member; a cavity constituted of a space surrounded by the frame member and the bottom surface member; a resin material supply mechanism which supplies a resin material into the cavity; a substrate transport mechanism which transports a substrate having an electronic component mounted on a main surface thereof to a space between the lower mold and the upper mold; a first drive mechanism which moves up and down the frame member; and a second drive mechanism which moves up and down the bottom surface member. A substrate pressing member provided in the frame member or the bottom surface member is moved up using the first drive mechanism or the second drive mechanism to bring a tip portion of the substrate pressing member into close contact with a predetermined region provided in the main surface of the substrate and press the predetermined region. In a state where the upper mold and the lower mold are closed, the electronic component is immersed in a fluid resin in the cavity. Since the predetermined region of the substrate is pressed by the substrate pressing member, it is possible to prevent the fluid resin from entering the predetermined region. Therefore, the surface-exposed state before resin sealing is performed can be maintained, with no sealing resin being formed at the predetermined region of the substrate.

### BRIEF DESCRIPTION OF DRAWINGS

Fig. 1 is a schematic partial cross sectional view showing a configuration of a device, in a first embodiment of a resin molding device in accordance with the present invention.
Fig. 2 is a schematic partial cross sectional view showing a state where a substrate is arranged on an upper mold and a resin material is supplied in a lower mold, in the first embodiment of the resin molding device in accordance with the present invention.
Fig. 3 is a schematic partial cross sectional view showing a state where the lower mold is moved up and substrate pressing pins are brought into close contact with the substrate, in the first embodiment of the resin molding device in accordance with the present invention.
Fig. 4 is a schematic partial cross sectional view showing a state where the lower mold is further moved up and the substrate is clamped by a side surface member, in the first embodiment of the resin molding device in accordance with the present invention.
Fig. 5 is a schematic partial cross sectional view showing a state where a bottom surface member is moved up to pressurize a fluid resin and produce a cured resin, in the first embodiment of the resin molding device in accordance with the present invention.
Fig. 6 is a schematic partial cross sectional view showing a state where the bottom surface member is moved down and released, in the first embodiment of the resin molding device in accordance with the present invention.
Fig. 7 is a schematic partial cross sectional view showing a state where a resin molded article is taken out by moving down the lower mold to open a mold, in the first embodiment of the resin molding device in accordance with the present invention.
Figs. 8(a) and 8(b) are schematic views each showing a shape of a tip portion of a substrate pressing pin used in the first embodiment.
Fig. 9 is a schematic partial cross sectional view showing a configuration of a device, in a second embodiment of the resin molding device in accordance with the present invention.
Fig. 10 is a schematic partial cross sectional view showing a configuration of a device, in a third embodiment of the resin molding device in accordance with the present invention.
Fig. 11 is a schematic partial cross sectional view showing a state where a lower mold is moved up and a substrate is clamped by a side surface member, in the third embodiment of the resin molding device in accordance with the present invention.
Fig. 12 is a schematic partial cross sectional view showing a state where a bottom surface member is moved up to pressurize a fluid resin and produce a cured resin, in the third embodiment of the resin molding device in accordance with the present invention.
Fig. 13 is a schematic partial cross sectional view showing a state where a resin molded article is taken out by moving down the lower mold to open a mold, in the third embodiment of the resin molding device in accordance with the present invention.
Fig. 14 is a plan view showing an overview of a device, in a fourth embodiment of the resin molding device in accordance with the present invention.

### DESCRIPTION OF EMBODIMENTS

As shown in Fig. 1, in a resin molding device 1, a lower mold 4 includes a side surface member 8, and a bottom surface member 9 which can be moved up and down inside side surface member 8. Substrate pressing pins 17 are provided in bottom surface member 9 constituting lower mold 4. A substrate 6 having a through hole and a connection electrode portion formed therein is fixed to an upper mold 3. Lower mold 4 (side surface member 8 and bottom surface member 9) is moved up to bring tip portions of substrate pressing pins 17 into close contact with the through hole and the connection electrode portion and press them. Lower mold 4 is further moved up, and thereby substrate 6 is clamped by an upper surface of side surface member 8, and the through hole and the connection electrode portion are further pressed by substrate pressing pins 17. Since substrate pressing pins 17 press the periphery of the through hole and the surface of the connection electrode portion, it is possible to prevent a fluid resin from entering the periphery of the through hole and the surface of the connection electrode portion. Therefore, the surface-exposed state before resin sealing is performed can be maintained, with no sealing resin being formed at predetermined regions where the through hole and the connection electrode portion are formed.

### First Embodiment

A first embodiment of the resin molding device in accordance with the present invention will be described with reference to Figs. 1 to 8. Any of the drawings in the document of the present application is drawn schematically with being omitted or exaggerated as appropriate for ease of comprehension. Identical components will be designated by the same reference numerals, and the description thereof may not be repeated as appropriate.

As shown in Fig. 1, in resin molding device 1, a mold 2 for compression molding includes upper mold 3 and lower mold 4 arranged to face upper mold 3. Upper mold 3 is provided with, for example, suction holes 7 which suction substrate 6 having a semiconductor chip 5 mounted thereon and fix it to upper mold 3. Semiconductor chip 5 is mounted on a main surface (a lower surface in the drawing) of substrate 6. A substrate fixing mechanism which fixes substrate 6 to upper mold 3 by hooks or the like instead of suction holes 7 may be provided.

Lower mold 4 includes frame-shaped side surface member 8, and bottom surface member 9 which can be relatively moved up and down with respect to side surface member 8 inside side surface member 8. A space surrounded by side surface member 8 and bottom surface member 9 constitutes a cavity 10 in lower mold 4. Upper mold 3 and lower mold 4 are provided with heating means (not shown) for heating a resin material supplied into cavity 10.

Side surface member 8 is coupled to a drive member 12 via an elastic member (first elastic member) 11 such as a compression spring. Drive member 12 is moved up and down by using a drive mechanism (first drive mechanism) 13. Drive mechanism 13 is fixed to a base 14 of resin molding device 1.

Bottom surface member 9 can be independently moved up and down inside side surface member 8 by using a drive mechanism (second drive mechanism) 15 provided to drive member 12. Drive mechanism 15 is fixed to drive member 12. In the drawing, drive mechanism 15 is provided on drive member 12. Alternatively, drive mechanism 15 may be provided inside drive member 12.

Side surface member 8 and bottom surface member 9 can be moved up or down simultaneously by moving up or down drive member 12 using drive mechanism 13. That is, lower mold 4 can be moved up or down by drive mechanism 13. By using drive mechanism 15, bottom surface member 9 is individually moved up and down inside side surface member 8. In addition, by synchronizing drive mechanism 13 and drive mechanism 15, side surface member 8 can be individually moved up and down apparently, in other words, when viewed from the outside of resin molding device 1. Upper mold 3 and lower mold 4 are closed by drive mechanism 13.

Spaces 16 are formed at predetermined regions of bottom surface member 9 constituting lower mold 4, and each substrate pressing pin 17 is provided within space 16. Substrate pressing pin 17 is elastically supported by an elastic member (second elastic member) 18, and can be moved up and down within space 16. In a state where upper mold 3 and lower mold 4 are opened, substrate pressing pins 17 are configured such that the tip portions thereof are higher than the upper surface of side surface member 8, in other words, an opening plane of cavity 10. Accordingly, substrate pressing pins 17 are provided in bottom surface member 9 such that the tip portions thereof protrude from cavity 10. In Fig. 1, the tip portions of substrate pressing pins 17 each has a tip surface formed as a flat surface. One or a plurality of substrate pressing pins 17 may be provided, as necessary.

When resin sealing is performed, substrate pressing pins 17 come into close contact with and press predetermined regions of substrate 6. This prevents a fluid resin from entering the predetermined regions. Therefore, portions of substrate 6 can be exposed at the predetermined regions, with no sealing resin being formed thereon. Substrate pressing pins 17 are provided in bottom surface member 9 such that the tip portions thereof protrude from cavity 10 to correspond to a product which is to be subjected to resin sealing. Resin molding device 1 shown in the first embodiment is a device which performs resin molding without using a mold release film.

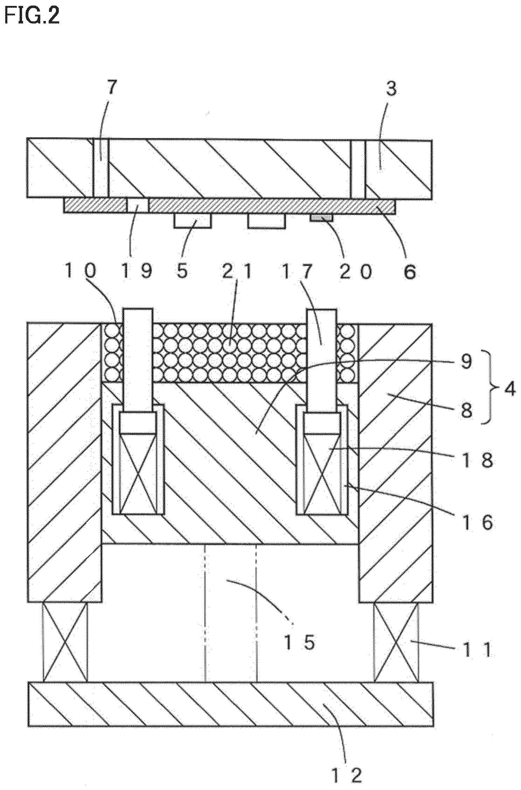

An operation of performing resin sealing on substrate 6 in resin molding device 1 in accordance with the present invention will be described with reference to Figs. 2 to 7. In Figs. 2 to 7, a description will be given with drive mechanism (first drive mechanism) 13 and drive mechanism (second drive mechanism) 15 shown in Fig. 1 being omitted. As shown in Fig. 2, upper mold 3 and lower mold 4 are opened. Then, using a substrate transport mechanism (not shown), substrate 6 having semiconductor chip 5 mounted thereon is transported to a predetermined position between upper mold 3 and lower mold 4. Then, substrate 6 is moved up and suctioned through suction holes 7 provided in upper mold 3. In this state, substrate 6 is fixed to a lower surface of upper mold 3 with the main surface having semiconductor chip 5 mounted thereon facing downward.

In substrate 6, for example, a through hole 19 for inserting an attachment tool such as an attaching screw, an attaching pin, or a positioning pin, and a connection electrode portion 20 such as a pad are formed at predetermined regions. Through hole 19 and connection electrode portion 20 are regions which are to be left with surfaces thereof being exposed, with no sealing resin being formed thereon. Accordingly, substrate pressing pins 17 are respectively provided at predetermined positions in bottom surface member 9 of lower mold 4, for example, so as to correspond to positions of through hole 19 and connection electrode portion 20. The tip surfaces of substrate pressing pins 17 press the periphery of through hole 19 and the surface of connection electrode portion 20, and thereby resin sealing can be performed with the surface-exposed regions being left, with no sealing resin being formed thereon. It should be noted that, instead of through hole 19, a blind hole may be formed at a predetermined region.

Next, a predetermined amount of resin material 21 is supplied into cavity 10 provided in lower mold 4, using a resin material supply mechanism (not shown). As resin material 21, a resin in the form of granules, powder, grains, paste, or jelly, a resin which is liquid at room temperature (liquid resin), or the like can be used. In the present embodiment, a description will be given of a case where a resin in the form of granules (granular resin) is used as resin material 21. Granular resin 21 is supplied by the resin material supply mechanism to substantially fill the volume of cavity 10.

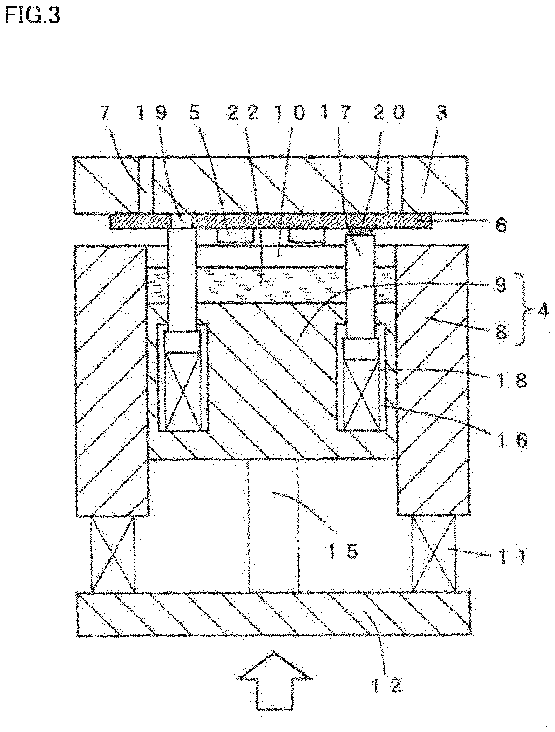

Next, as shown in Fig. 3, granular resin 21 is heated by the heating means (not shown) provided in upper mold 3 and lower mold 4. By heating, granular resin 21 is melted to produce a fluid resin 22. By melting, the volume of granular resin 21 is considerably decreased. Therefore, it is necessary to supply the predetermined amount of granular resin 21 into cavity 10, considering the thickness of a package to be subjected to resin sealing. It should be noted that, when a liquid resin is supplied into cavity 10 as resin material 21, the liquid resin itself corresponds to fluid resin 22.

Then, drive member 12 is moved up using drive mechanism 13 (see Fig. 1). By moving up drive member 12, side surface member 8 and bottom surface member 9 constituting lower mold 4 are simultaneously moved up. Drive mechanism 15 (see Fig. 1), which is in a stopped state, is moved up together with drive member 12. As bottom surface member 9 is moved up, the tip portions of substrate pressing pins 17 provided in bottom surface member 9 come into close contact with through hole 19 and connection electrode portion 20 provided in substrate 6. The tip surfaces of two substrate pressing pins 17 come into close contact with and press the periphery of through hole 19 and the surface of connection electrode portion 20, respectively. This can prevent fluid resin 22 from entering the periphery of through hole 19 and the surface of connection electrode portion 20 when resin sealing is performed.

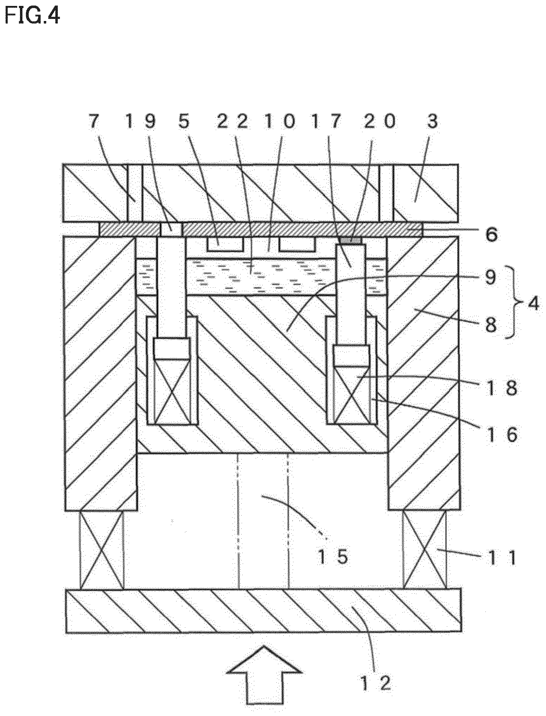

Next, as shown in Fig. 4, drive member 12 is further moved up, and thereby side surface member 8 and bottom surface member 9 are simultaneously moved up. As side surface member 8 is moved up, the upper surface of side surface member 8 comes into contact with a peripheral edge portion in the main surface (the lower surface in the drawing) of substrate 6, and clamps substrate 6. Thereby, upper mold 3 and lower mold 4 are closed. Therefore, cavity 10 is sealed by upper mold 3 and lower mold 4. In this state, semiconductor chip 5 is not immersed in fluid resin 22 yet. It should be noted that, in this case, side surface member 8 and bottom surface member 9 are simultaneously moved up to clamp substrate 6. Alternatively, only side surface member 8 can be moved up to clamp substrate 6.

As bottom surface member 9 is moved up, elastic members (second elastic members) 18 pressing substrate pressing pins 17 receive a reaction from substrate 6, and are compressed within spaces 16. As elastic members 18 are compressed, substrate pressing pins 17 further strongly and uniformly press the periphery of through hole 19 and the surface of connection electrode portion 20.

It should be noted that, in the process of closing upper mold 3 and lower mold 4, it is preferable to suction the air and reduce the pressure inside cavity 10 using a vacuuming mechanism (not shown). Thereby, the air remaining in cavity 10, air bubbles included in fluid resin 22, and the like can be exhausted out of mold 2.

Next, as shown in Fig. 5, only bottom surface member 9 is moved up using drive mechanism 15 (see Fig. 1). Bottom surface member 9 is moved up inside side surface member 8. Thereby, semiconductor chip 5 is immersed in fluid resin 22 in cavity 10. Since the periphery of through hole 19 and the surface of connection electrode portion 20 are strongly pressed by substrate pressing pins 17, it is possible to prevent fluid resin 22 from entering the periphery of through hole 19 and the surface of connection electrode portion 20. In this state, fluid resin 22 is compressed at a predetermined pressure. By applying a pressure at a predetermined temperature for a predetermined time, fluid resin 22 is cured to form a cured resin 23. Thus, semiconductor chip 5 mounted on substrate 6 and the main surface (the lower surface in the drawing) of substrate 6 in cavity 10 are sealed with cured resin 23, except for the portions (predetermined regions) pressed by substrate pressing pins 17.

In resin molding device 1, only bottom surface member 9 can be individually moved up and down using drive mechanism 15. After the tip portions of substrate pressing pins 17 come into contact with through hole 19 and connection electrode portion 20, bottom surface member 9 can be moved up within a range in which elastic members 18 deform within spaces 16. Therefore, within that range, the thickness of cured resin 23, in other words, the thickness of the package can be adjusted.

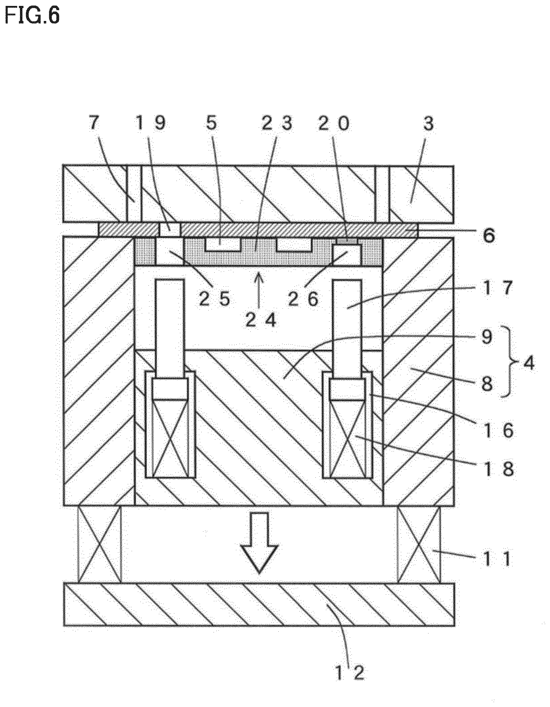

Next, as shown in Fig. 6, after a resin molded article 24 having substrate 6, semiconductor chip 5, and cured resin 23 is formed, bottom surface member 9 is moved down using drive mechanism 15 (see Fig. 1), with substrate 6 being clamped by side surface member 8. By moving down bottom surface member 9, bottom surface member 9 is released from resin molded article 24. Bottom surface member 9 is moved down to a position where the tip portions of substrate pressing pins 17 are disconnected from resin molded article 24, and thereby is released. Since only bottom surface member 9 is moved down without moving down side surface member 8, bottom surface member 9 can be stably released from resin molded article 24. As bottom surface member 9 is moved down, compressed elastic members 18 are released and move up to the initial position.

As bottom surface member 9 is released, a space 25 and a space 26 corresponding to the shapes of substrate pressing pins 17 are respectively formed on through hole 19 and connection electrode portion 20 formed in substrate 6 (toward a lower side of substrate 6 in Fig. 6) in resin mold article 24. Therefore, at the predetermined regions where through hole 19 and connection electrode portion 20 are formed, the surface-exposed state before resin sealing is performed can be maintained.

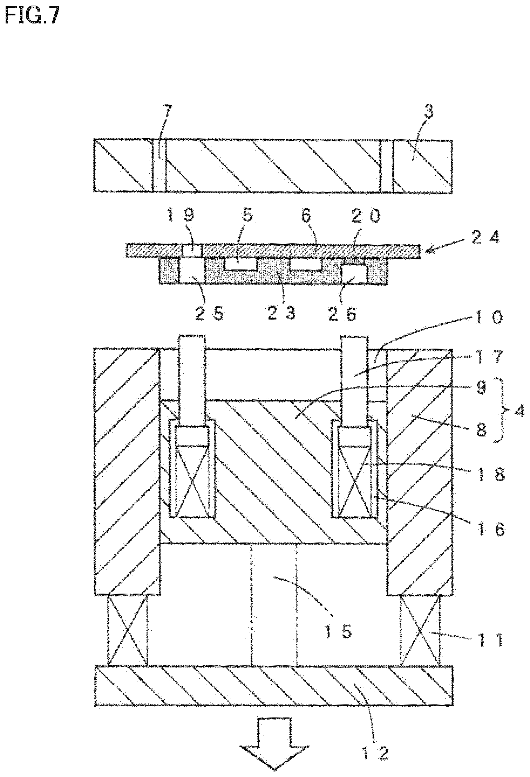

Next, as shown in Fig. 7, drive member 12 is moved down while synchronizing drive mechanism 13 (see Fig. 1) and drive mechanism 15 (see Fig. 1). Thereby, side surface member 8 and bottom surface member 9 are moved down to the original positions. In this state, upper mold 3 and lower mold 4 are opened. Then, suctioning of resin molded article 24 subjected to resin sealing is stopped, and thereafter resin molded article 24 is taken out of upper mold 3. Taken-out resin molded article 24 is stored in a substrate storage portion by the substrate transport mechanism (not shown).

When lower mold 4 is released from resin molded article 24, mold release is performed by first moving down bottom surface member 9 and then moving down side surface member 8. Alternatively, mold release can be performed by first moving down side surface member 8 and then moving down bottom surface member 9.

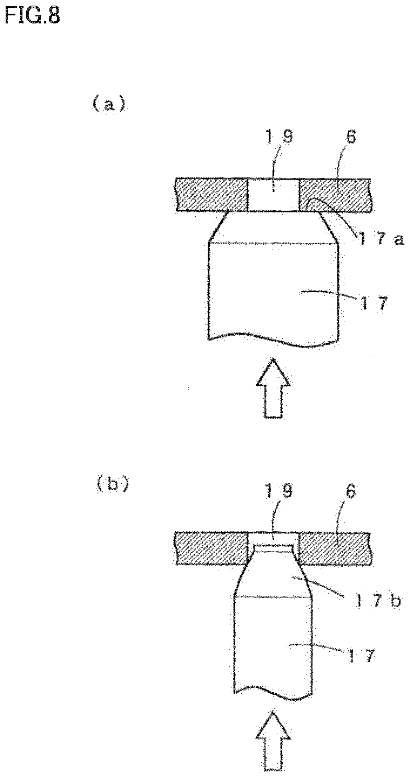

Figs. 8(a) and 8(b) each show a shape of a tip portion of substrate pressing pin 17 which presses through hole 19 formed in substrate 6. In Fig. 8(a), the size of a tip surface 17a of substrate pressing pin 17 is formed larger than the size of through hole 19. Therefore, as tip surface 17a of substrate pressing pin 17 presses the periphery of through hole 19, it is possible to prevent fluid resin 22 from entering from the periphery of through hole 19 into through hole 19. Tip surface 17a of substrate pressing pin 17 is a flat surface, or a curved surface having a large radius of curvature (a substantially flat surface). It should be noted that substrate pressing pin 17 of Fig. 8(a) can also press the surface of connection electrode portion 20 (Figs. 2 to 7) formed in substrate 6.

In Fig. 8(b), a tapered portion 17b in a shape which can enter into through hole 19 (between a front surface and a back surface of substrate 6) is provided at the tip portion of substrate pressing pin 17. Tapered portion 17b is inserted into through hole 19, and tapered portion 17b blocks through hole 19. By providing tapered portion 17b, a pressing force used to press substrate 6 can be increased and stabilized. Therefore, as tapered portion 17b blocks through hole 19, it is possible to prevent fluid resin 22 from entering from the periphery of through hole 19 into through hole 19.

A film of engineering plastic (PTFE, PEEK, or the like) may be formed on tip surface 17a of substrate pressing pin 17 of Fig. 8(a) (an upper surface in the drawing) and at least a surface of tapered portion 17b of substrate pressing pin 17 of Fig. 8(b). This suppresses occurrence of a flaw, deformation, and the like in substrate 6.

According to the present embodiment, in resin molding device 1, substrate pressing pins 17 are provided in bottom surface member 9 constituting lower mold 4. Substrate 6 having through hole 19 and connection electrode portion 20 formed therein is fixed to upper mold 3. By moving up lower mold 4 (side surface member 8 and bottom surface member 9), the tip portions of substrate pressing pins 17 come into close contact with and press through hole 19 and connection electrode portion 20. By further moving up lower mold 4, the upper surface of side surface member 8 clamps substrate 6, and substrate pressing pins 17 further press through hole 19 and connection electrode portion 20. Since substrate pressing pins 17 press the periphery of through hole 19 and the surface of connection electrode portion 20, it is possible to prevent fluid resin 22 from entering the periphery of through hole 19 and the surface of connection electrode portion 20. Therefore, the surface-exposed state before resin sealing is performed can be maintained, with no sealing resin being formed at the predetermined regions where through hole 19 and connection electrode portion 20 are formed.

Further, according to the present embodiment, in the state where upper mold 3 and lower mold 4 are opened, substrate pressing pins 17 are configured such that the tip portions thereof are higher than the upper surface of side surface member 8. In other words, substrate pressing pins 17 are provided in bottom surface member 9 such that the tip portions thereof protrude from cavity 10. By moving up lower mold 4, first, substrate pressing pins 17 come into close contact with and press through hole 19 and connection electrode portion 20. Then, the upper surface of side surface member 8 comes into close contact with substrate 6 and clamps substrate 6. In this state, the periphery of through hole 19 and the surface of connection electrode portion 20 are pressed by substrate pressing pins 17 stably and strongly. Therefore, fluid resin 22 can be reliably prevented from entering the periphery of through hole 19 and the surface of connection electrode portion 20.

Further, according to the present embodiment, in resin molding device 1, two drive mechanisms are provided, making it possible to separately drive side surface member 8 and bottom surface member 9. Side surface member 8 and bottom surface member 9 can be simultaneously moved up and down using drive mechanism (first drive mechanism) 13. Only bottom surface member 9 can be moved up and down using drive mechanism (second drive mechanism) 15. Furthermore, side surface member 8 can be individually moved up and down by synchronizing drive mechanism 13 and drive mechanism 15. Therefore, after resin molding, bottom surface member 9 and side surface member 8 can be separately moved down and released. Since bottom surface member 9 and side surface member 8 can be separately released, mold release can be facilitated.

Further, according to the present embodiment, mold release is facilitated by separately driving side surface member 8 and bottom surface member 9. Therefore, resin sealing can be performed without using a mold release film. Since a mold release film is not used, the material cost in resin sealing can be reduced, and the configuration of resin molding device 1 can be simplified.

Further, according to the present embodiment, in resin molding device 1, substrate pressing pins 17 are provided within spaces 16 in bottom surface member 9. Within each space 16, substrate pressing pin 17 is elastically supported by elastic member 18. After the tip portions of substrate pressing pins 17 come into contact with through hole 19 and connection electrode portion 20, bottom surface member 9 can be moved up within the range in which elastic members 18 deform within spaces 16. Therefore, within that range, the thickness of cured resin 23 (the thickness of the package) can be adjusted.

Further, according to the present embodiment, the predetermined regions of substrate 6 to be subjected to resin sealing can be exposed by substrate pressing pins 17. Therefore, there is no need to provide later a new opening in resin molded article 24 in order to stack substrates 6. Since exposed portions can be easily formed at the predetermined regions of substrate 6, the degree of freedom of wiring is increased. Therefore, the wiring resistance and the packaging area of the product can be decreased, and thus a high-performance, highly integrated semiconductor device can be implemented.

### Second Embodiment

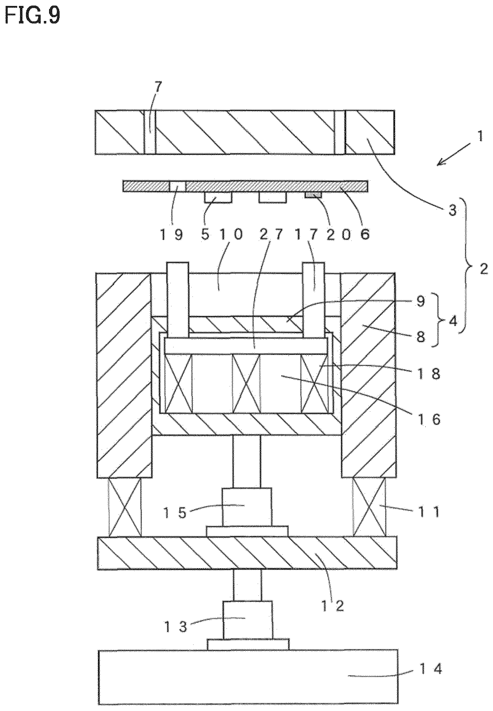

A second embodiment of resin molding device 1 in accordance with the present invention will be described with reference to Fig. 9. The second embodiment is different from the first embodiment in that one large space 16 is formed in bottom surface member 9, and within this space 16, a substrate pressing plate 27 having a plurality of substrate pressing pins 17 arranged thereon is provided. Since other components and operations are the same as those in the first embodiment, the description thereof will not be repeated.

As shown in Fig. 9, large space 16 is formed in bottom surface member 9. Within this space 16, substrate pressing plate 27 having the plurality of substrate pressing pins 17 arranged thereon is provided. Substrate pressing plate 27 is elastically supported by one or a plurality of elastic members 18, and can be moved up and down within space 16. By elastically supporting substrate pressing plate 27 by the plurality of elastic members 18, the plurality of substrate pressing pins 17 arranged on substrate pressing plate 27 can be uniformly pressed. As in the first embodiment, in the state where upper mold 3 and lower mold 4 are opened, substrate pressing pins 17 are configured such that the tip portions thereof are higher than the upper surface of side surface member 8. Therefore, substrate pressing plate 24 is provided within space 16 in bottom surface member 9 such that the tip portions of substrate pressing pins 17 protrude from cavity 10.

The present embodiment exhibits the same effect as that in the first embodiment. In addition, since only one large space 16 is formed in bottom surface member 9, processing of bottom surface member 9 can be simplified. Lower mold 4 can be fabricated more easily, and cost can be suppressed. Therefore, cost reduction of resin molding device 1 can be achieved.

### Third Embodiment

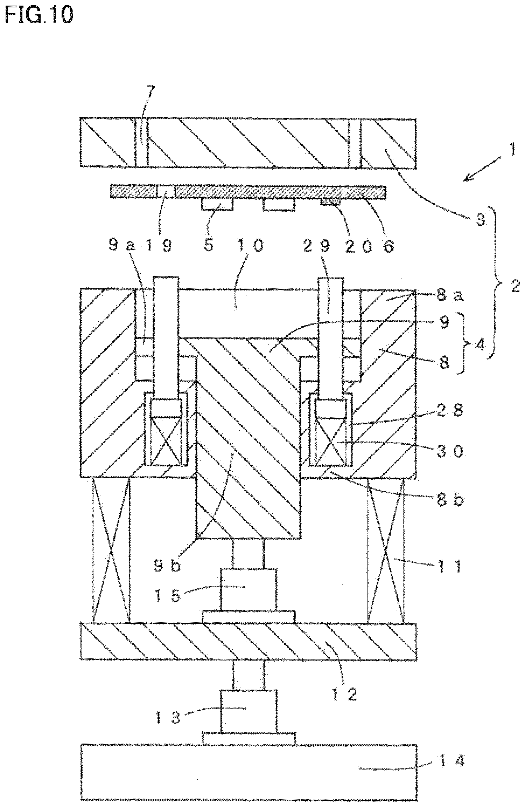

A third embodiment of resin molding device 1 in accordance with the present invention will be described with reference to Fig. 10. The third embodiment is different from the first embodiment in that spaces are formed at predetermined regions of side surface member 8, and substrate pressing pins are respectively provided within the spaces. Therefore, the shapes of side surface member 8 and bottom surface member 9 constituting lower mold 4 are different from those in the first embodiment. Other components and operations are the same as those in the first embodiment.

As shown in Fig. 10, side surface member 8 includes an upper member 8a and a lower member 8b. Lower member 8b is formed to project inward with respect to upper member 8a. Bottom surface member 9 includes an upper member 9a and a lower member 9b. Upper member 9a is formed to project outward with respect to lower member 9b. A space surrounded by an upper portion (a portion including an upper end surface) of upper member 8a of side surface member 8 and upper member 9a of bottom surface member 9 constitutes cavity 10 in lower mold 4. Lower member 9b of bottom surface member 9 is moved up and down by drive member 15, along a side surface of lower member 8b of side surface member 8. As in the first embodiment, in the state where upper mold 3 and lower mold 4 are opened, side surface member 8 and bottom surface member 9 can be moved up and down by drive mechanism 13 and drive mechanism 15, respectively.

Spaces 28 are formed at predetermined regions of lower member 8b constituting side surface member 8, and each substrate pressing pin 29 is provided within space 28. Substrate pressing pin 29 is elastically supported by an elastic member (third elastic member) 30, and can be moved up and down within space 28. As in the first embodiment, in the state where upper mold 3 and lower mold 4 are opened, substrate pressing pins 29 are configured such that tips thereof are higher than the upper surface of side surface member 8. Accordingly, substrate pressing pins 29 are provided in side surface member 9 such that the tips thereof protrude from cavity 10.

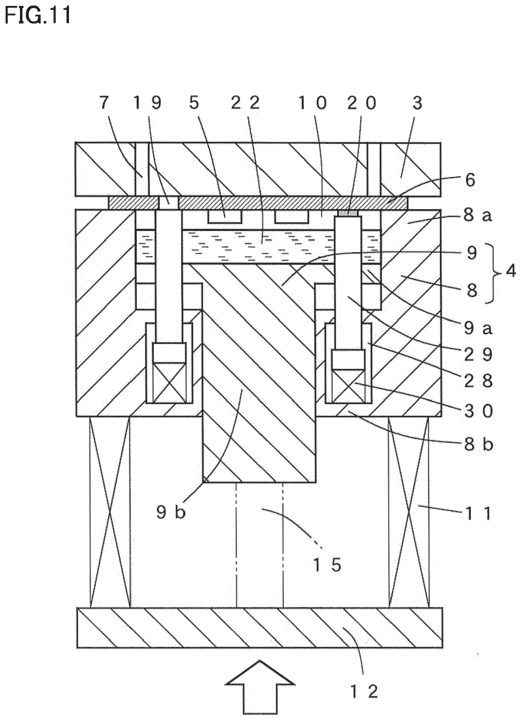

An operation of performing resin sealing on substrate 6 in the third embodiment of resin molding device 1 in accordance with the present invention will be described with reference to Figs. 11 to 13. In Figs. 11 to 13, a description will be given with drive mechanism (first drive mechanism) 13 and drive mechanism (second drive mechanism) 15 shown in Fig. 10 being omitted. Since the operation of fixing substrate 6 to upper mold 3 and the operation of supplying granular resin 21 into cavity 10 and heating it to produce fluid resin 22 in Fig. 10 are the same as those in the first embodiment, the description thereof will not be repeated.

As shown in Fig. 11, drive member 12 is moved up using drive mechanism 13 (see Fig. 10), and thereby side surface member 8 and bottom surface member 9 constituting lower mold 4 are simultaneously moved up. First, tip portions of substrate pressing pins 29 provided in side surface member 8 come into close contact with and press through hole 19 and connection electrode portion 20 provided in substrate 6. Side surface member 8 and bottom surface member 9 are further moved up simultaneously by drive mechanism 13. The upper surface of side surface member 8 comes into close contact with the main surface (the lower surface in the drawing) of substrate 6, and clamps substrate 6. Thereby, upper mold 3 and lower mold 4 are closed.

As side surface member 8 is moved up, elastic members (third elastic members) 30 pressing substrate pressing pins 29 receive a reaction from substrate 6, and are compressed within spaces 28. As elastic members 30 are compressed, substrate pressing pins 29 further strongly and uniformly press the periphery of through hole 19 and the surface of connection electrode portion 20.

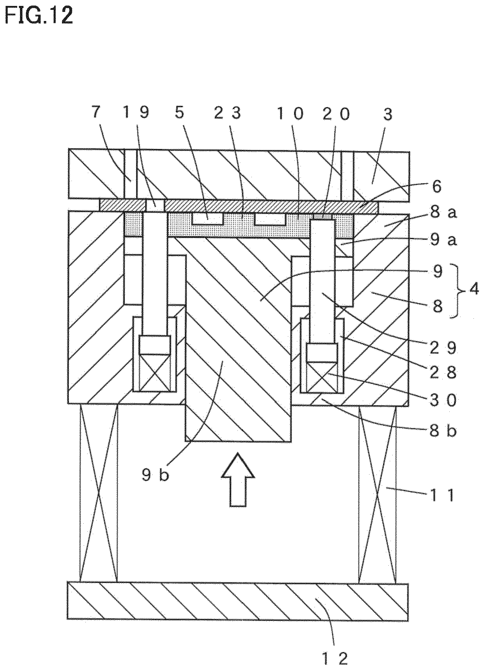

Next, as shown in Fig. 12, bottom surface member 9 is moved up using drive mechanism 15 (see Fig. 10). Thereby, semiconductor chip 5 is immersed in fluid resin 22 in cavity 10. Since the periphery of through hole 19 and the surface of connection electrode portion 20 are strongly pressed by substrate pressing pins 29, it is possible to prevent fluid resin 22 from entering the periphery of through hole 19 and the surface of connection electrode portion 20. In this state, fluid resin 22 is compressed at a predetermined pressure. By applying a pressure at a predetermined temperature for a predetermined time, fluid resin 22 is cured to mold cured resin 23. Thus, semiconductor chip 5 mounted on substrate 6 and the main surface of substrate 6 in cavity 10 are sealed with cured resin 23, except for the portions (predetermined regions) pressed by substrate pressing pins 29.

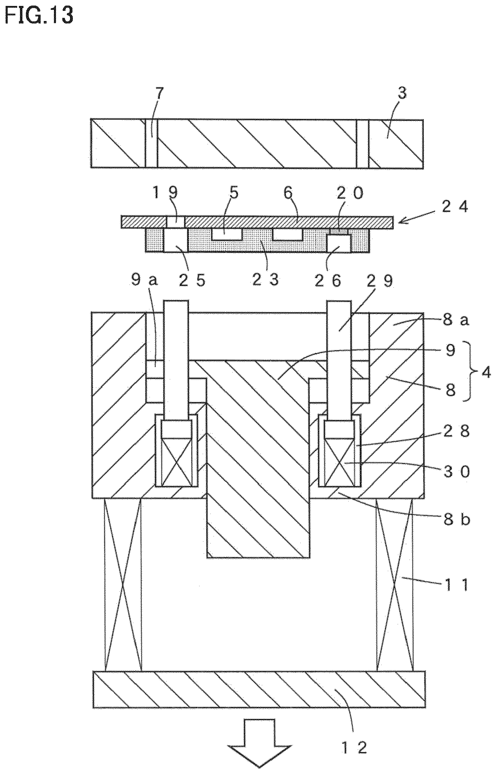

Next, as in the steps shown in Figs. 6 and 7, first, bottom surface member 9 is moved down, with substrate 6 being clamped by side surface member 8. By moving down bottom surface member 9, bottom surface member 9 is released from resin molded article 24. Since only bottom surface member 9 is moved down without moving down side surface member 8, bottom surface member 9 can be stably released from resin molded article 24. Next, while synchronizing drive mechanism 13 (see Fig. 10) and drive mechanism 15 (see Fig. 10), side surface member 8 and bottom surface member 9 are moved down to the original positions. As shown in Fig. 13, in this state, upper mold 3 and lower mold 4 are opened. Then, resin molded article 24 subjected to resin sealing is taken out of upper mold 3.

According to the present embodiment, in resin molding device 1, substrate pressing pins 29 are provided in side surface member 8 constituting lower mold 4. Substrate 6 having through hole 19 and connection electrode portion 20 formed therein is fixed to upper mold 3. By moving up lower mold 4 (side surface member 8 and bottom surface member 9), the tip portions of substrate pressing pins 29 come into close contact with and press through hole 19 and connection electrode portion 20. By further moving up lower mold 4, the upper surface of side surface member 8 clamps substrate 6, and substrate pressing pins 29 further press through hole 19 and connection electrode portion 20. Since substrate pressing pins 29 press the periphery of through hole 19 and the surface of connection electrode portion 20, it is possible to prevent fluid resin 22 from entering the periphery of through hole 19 and the surface of connection electrode portion 20. Therefore, the surface-exposed state before resin sealing is performed can be maintained, with no sealing resin being formed at the predetermined regions where through hole 19 and connection electrode portion 20 are formed.

Further, according to the present embodiment, in the state where upper mold 3 and lower mold 4 are opened, substrate pressing pins 29 are configured such that the tip portions thereof are higher than the upper surface of side surface member 8. In other words, substrate pressing pins 29 are provided in side surface member 8 such that the tip portions thereof protrude from cavity 10. By moving up lower mold 4, first, substrate pressing pins 29 come into close contact with through hole 19 and connection electrode portion 20, and then the upper surface of side surface member 8 comes into close contact with substrate 6 and clamps substrate 6. In this state, the periphery of through hole 19 and the surface of connection electrode portion 20 are pressed by substrate pressing pins 29 stably and strongly. Therefore, fluid resin 22 can be reliably prevented from entering the periphery of through hole 19 and the surface of connection electrode portion 20.

Further, according to the present embodiment, in resin molding device 1, substrate pressing pins 29 are provided within spaces 28 in side surface member 8. Within each space 28, substrate pressing pin 29 is elastically supported by elastic member 30. After the tip portions of substrate pressing pins 29 come into contact with and press through hole 19 and connection electrode portion 20, and the upper surface of side surface member 8 clamps substrate 6, elastic members 30 maintain a compressed state within spaces 28. In this state, bottom surface member 9 can be moved up by drive mechanism 15. Therefore, within a range in which bottom surface member 9 is moved up, the thickness of cured resin 23 (the thickness of the package) can be adjusted without limitation.

It should be noted that, according to the present embodiment, one elastic member 30 and one substrate pressing pin 29 are provided in each space 28, as shown in Fig. 10. Alternatively, substrate pressing plate 27 having the plurality of (two in Fig. 9) substrate pressing pins 17 attached thereto and one or the plurality of elastic members 18 elastically supporting substrate pressing plate 27 shown in Fig. 9 may be used. In this case, substrate pressing plate 27 having the plurality of substrate pressing pins 17 attached thereto and elastic member(s) 18 elastically supporting substrate pressing plate 27 shown in Fig. 9 are arranged in each space 28 in Fig. 10.

### Fourth Embodiment

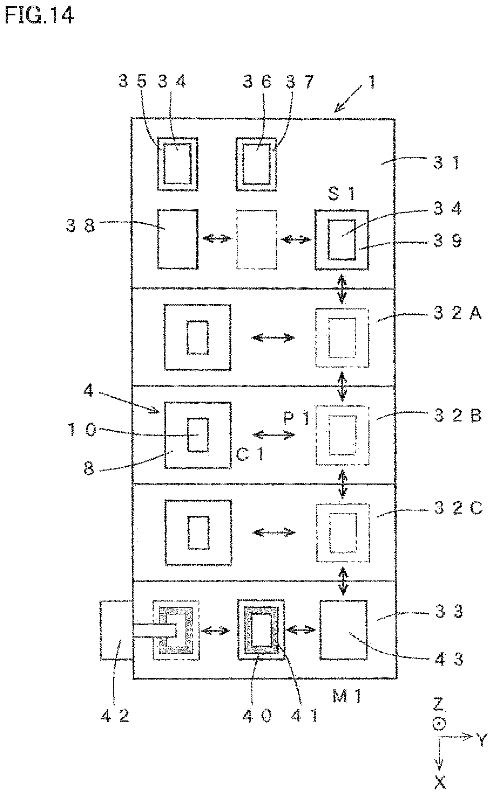

A fourth embodiment of resin molding device 1 in accordance with the present invention will be described with reference to Fig. 14. Resin molding device 1 shown in Fig. 14 includes a substrate supply/storage module 31, three molding modules 32A, 32B, 32C, and a resin material supply module 33, as components. Substrate supply/storage module 31, three molding modules 32A, 32B, 32C, and resin material supply module 33 serving as components are each attachable to and detachable from another component, and are interchangeable with each other.

Substrate supply/storage module 31 is provided with a pre-sealing substrate supply portion 35 which supplies a pre-sealing substrate 34, a sealed substrate storage portion 37 which stores a sealed substrate 36, a substrate placement portion 38 which receives and passes pre-sealing substrate 34 and sealed substrate 36, and a substrate transport mechanism 39 which transports pre-sealing substrate 34 and sealed substrate 36. Substrate placement portion 38 moves in a Y direction within substrate supply/storage module 31. Substrate transport mechanism 39 moves in an X direction and the Y direction within substrate supply/storage module 31 and each molding module 32A, 32B, 33C. A predetermined position S1 is a position where substrate transport mechanism 39 is on standby in an non-operating state.

Each molding module 32A, 32B, 33C is provided with lower mold 4 and upper mold 3 arranged to face lower mold 4 (see Fig. 1). Upper mold 3 and lower mold 4 constitute mold 2. Lower mold 4 includes side surface member 8 and bottom surface member 9 (see Fig. 1) which can be moved up and down independently. Each molding module 32A, 32B, 33C has drive mechanism 13 which moves up and down side surface member 8, and drive mechanism 15 which moves up and down bottom surface member 9 (see Fig. 1). Cavity 10 surrounded by side surface member 8 and bottom surface member 9 is provided in lower mold 4.

Resin material supply module 33 is provided with an X-Y table 40, a resin material accommodation portion 41 placed on X-Y table 40, a resin material loading mechanism 42 which loads resin material 21 (see Fig. 2) into resin material accommodation portion 41, and a resin material supply mechanism 43 which transports resin material accommodation portion 41 and supplies resin material 21 into cavity 10. X-Y table 40 moves in the X direction and the Y direction within resin material supply module 33. Resin material supply mechanism 43 moves in the X direction and the Y direction within resin material supply module 33 and each molding module 32A, 32B, 33C. A predetermined position M1 is a position where resin material supply mechanism 43 is on standby in an non-operating state.

An operation of performing resin sealing using resin molding device 1 will be described with reference to Fig. 14. First, in substrate supply/storage module 31, pre-sealing substrate 34 is passed from pre-sealing substrate supply portion 35 to substrate placement portion 38. Then, substrate transport mechanism 39 is moved in the -Y direction from predetermined position S1 to receive pre-sealing substrate 34 from substrate placement portion 38. Substrate transport mechanism 39 is returned to predetermined position S1. Then, substrate transport mechanism 39 is moved in the +X direction to a predetermined position P1 in molding module 32B, for example. Next, in molding module 32B, substrate transport mechanism 39 is moved in the -Y direction, and is stopped at a predetermined position C1 above lower mold 4. Then, substrate transport mechanism 39 is moved up to fix pre-sealing substrate 34 to upper mold 3 (see Fig. 1). Substrate transport mechanism 39 is returned to predetermined position S1 in substrate supply/storage module 31.

Next, in resin material supply module 33, X-Y table 40 is moved in the -Y direction, and resin material accommodation portion 41 is stopped at a predetermined position below resin material loading mechanism 42. Then, X-Y table 40 is moved in the X direction and the Y direction while resin material 21 (see Fig. 2) is loaded from resin material loading mechanism 42 into resin material accommodation portion 41. Thereby, a predetermined amount of resin material 21 is loaded from resin material loading mechanism 42 into resin material accommodation portion 41. X-Y table 40 is moved in the +Y direction to be returned to its original position.

Subsequently, resin material supply mechanism 43 is moved in the -Y direction from predetermined position M1 to receive resin material accommodation portion 41 placed on X-Y table 40. Resin material supply mechanism 43 is returned to its original position M1. Then, resin material supply mechanism 43 is moved in the -X direction to predetermined position P1 in molding module 32B. Next, in molding module 32B, resin material supply mechanism 43 is moved in the -Y direction, and is stopped at predetermined position C1 above lower mold 4. Then, resin material supply mechanism 43 is moved down to supply resin material 21 accommodated in resin material accommodation portion 41 into cavity 10. Resin material supply mechanism 43 is returned to predetermined position M1.

Subsequently, in molding module 32B, upper mold 3 and lower mold 4 are closed by moving up side surface member 8 and bottom surface member 9 (see Figs. 3 to 5). After a predetermined time elapses, upper mold 3 and lower mold 4 are opened (see Figs. 6 and 7). Next, substrate transport mechanism 39 is moved from predetermined position S1 in substrate supply/storage module 32 to predetermined position C1 above lower mold 4 to receive sealed substrate 36. Then, substrate transport mechanism 39 is moved through predetermined position S1 to above substrate placement portion 38, to pass sealed substrate 36 to substrate placement portion 38. Sealed substrate 36 is stored from substrate placement portion 38 into sealed substrate storage portion 37. Thereby, resin sealing is completed.

In the present embodiment, three molding modules 32A, 32B, and 32C are arranged side by side in the X direction between substrate supply/storage module 31 and resin material supply module 33. Substrate supply/storage module 31 and resin material supply module 33 may be provided as one module, and one molding module 32A may be arranged adjacent to the one module in the X direction. Thereby, the number of molding modules 32A, 32B, ... can be increased or decreased. Therefore, the configuration of resin molding device 1 can be optimized corresponding to the type of production or the amount of production, and thus productivity can be improved.

It should be noted that the resin molding device and resin molding method used when sealing a semiconductor chip with resin have been described in each embodiment. Resin sealing may be performed on a semiconductor chip such as an IC or a transistor, or a chip of a passive element. The present invention is applicable when sealing one or a plurality of chips mounted on a substrate such as a lead frame, a printed circuit substrate, or a ceramic substrate, with a cured resin. Therefore, the present invention is also applicable when manufacturing a multichip package, a multichip module, a hybrid IC, a control module for a power system, and the like.

One or a plurality of products may be manufactured from one substrate 6. When a plurality of products are manufactured from one substrate 6, sealed substrate 36 is separated at predetermined boundary lines in sealed substrate 36. Thereby, sealed substrate 36 is singulated to manufacture the plurality of products.

As the relation between drive mechanisms 13, 15 and side and bottom surface members 8, 9, the following configuration may be adopted. First, in order to move up and down bottom surface member 9, drive member 12 is moved up and down using drive mechanism 13 fixed to base 14 of resin molding device 1, as shown in Fig. 1. The configuration described below is not shown in Fig. 1. Drive member 12 is moved up and down using drive mechanism 13 (second drive mechanism) via an appropriate coupling member provided in drive member 12 and coupled to bottom surface member 9, and thereby bottom surface member 9 is moved up and down. Then, in order to move up and down side surface member 8, drive mechanism (first drive mechanism) 15 fixed to drive member 12 is driven. Thereby, side surface member 8 is moved up and down via an appropriate coupling member provided in side surface member 8 and coupled to drive mechanism (first drive mechanism) 15.

As the manner in which drive mechanism 13 and drive mechanism 15 are fixed to resin molding device 1, the following configuration may be adopted. First drive mechanism 13 is fixed to base 14 of resin molding device 1, and drive member 12 is moved up and down using first drive mechanism 13, as shown in Fig. 1. The configuration described below is not shown in Fig. 1. A frame-shaped rack is fixed to base 14, and first drive mechanism 13 is arranged inside the rack. A through hole is provided in drive member 12, and the rack is arranged to overlap with the through hole when viewed in a plan view. Thereby, drive member 12 is moved up and down without being disturbed by the rack. The rack is provided with an attachment plate, and drive mechanism 15 is fixed to the attachment plate. Bottom surface member 9 and side surface member 8 can be completely independently moved up and down in any of the following manners. As a first manner, side surface member 8 is moved up and down by drive member 12 which is moved up and down using drive mechanism (first drive mechanism) 13, and bottom surface member 9 is moved up and down using drive mechanism (second drive mechanism) 15. As a second manner, bottom surface member 9 is moved up and down using drive mechanism (second drive mechanism) 13, and side surface member 8 is moved up and down using drive mechanism (first drive mechanism) 15.

The description has been given of the case where cavity 10 is provided in lower mold 4 in resin molding device 1. Other than this configuration, cavity 10 may be provided in upper mold 3, or cavity 10 may be provided in both lower mold 4 and upper mold 3. When cavity 10 is provided in upper mold 3, a resin material having a high viscosity, such as that in the form of paste or jelly, is used. In this case, the resin material can be supplied into cavity 10 provided in upper mold 3. The resin material may be supplied on substrate 6 arranged to face cavity 10 provided in upper mold 3.

The present invention is not limited to the embodiments described above, and can be adopted by arbitrarily and appropriately combining, modifying, or selecting the embodiments as necessary, within a range not departing from the gist of the present invention.

### REFERENCE SIGNS LIST

1: resin molding device; 2: mold; 3: upper mold; 4: lower mold; 5: semiconductor chip (electronic component); 6: substrate; 7: suction hole; 8: side surface member (frame member); 8a: upper member; 8b: lower member; 9: bottom surface member; 9a: upper member; 9b: lower member; 10: cavity; 11: elastic member; 12: drive member; 13: drive mechanism (first drive mechanism, second drive mechanism); 14: base; 15: drive mechanism (second drive mechanism, first drive mechanism); 16: space; 17: substrate pressing pin (substrate pressing member); 17a: tip surface; 17b: tapered portion (tip portion); 18: elastic member (elastic body); 19: through hole (hole); 20: connection electrode portion; 21: resin material; 22: fluid resin; 23: cured resin; 24: resin molded article; 25: space; 26: space; 27: substrate pressing plate (attachment plate); 28: space; 29: substrate pressing pin (substrate pressing member); 30: elastic member (elastic body); 31: substrate supply/storage module; 32A, 32B, 32C: molding module; 33: resin material supply module; 34: pre-sealing substrate; 35: pre-sealing substrate supply portion; 36: sealed substrate; 37: sealed substrate storage portion; 38: substrate placement portion; 39: substrate transport mechanism; 40: X-Y table; 41: resin material accommodation portion; 42: resin material loading mechanism; 43: resin material supply mechanism; S1, P1, C1, M1: predetermined position.

## Claims

1. A resin molding device, comprising:
an upper mold;
a lower mold provided to face the upper mold;
a frame member provided at least in the lower mold;
a bottom surface member which is provided at least in the lower mold, and can be relatively moved up and down with respect to the frame member inside the frame member;
a cavity constituted of a space surrounded by the frame member and the bottom surface member;
a resin material supply mechanism which supplies a resin material into the cavity;
a substrate transport mechanism which transports a substrate having an electronic component mounted on a main surface thereof to a space between the lower mold and the upper mold;
a first drive mechanism which moves up and down the frame member; and
a second drive mechanism which moves up and down the bottom surface member,
**characterized in that**
the resin molding device comprises a substrate pressing member provided in the frame member or the bottom surface member, and a tip portion provided in the substrate pressing member,
the tip portion of the substrate pressing member is brought into close contact with a predetermined region provided in the main surface of the substrate and presses the predetermined region, by moving up the substrate pressing member using the first drive mechanism or the second drive mechanism, and
in a state where the upper mold and the lower mold are closed by moving up the frame member and the bottom surface member, the electronic component is immersed in a fluid resin produced from the resin material in the cavity, and the electronic component is sealed with a cured resin formed by curing the fluid resin, with the predetermined region being exposed from the cured resin.

2. The resin molding device according to claim 1, **characterized in that**, in a state where the upper mold and the lower mold are opened, the tip portion of the substrate pressing member is formed to be higher than an upper surface of the frame member.

3. The resin molding device according to claim 1, **characterized by** comprising an elastic body supporting the substrate pressing member.

4. The resin molding device according to claim 1, **characterized by** comprising:
one or a plurality of the substrate pressing members;
an attachment plate having the one or plurality of the substrate pressing members attached thereto; and
one or a plurality of elastic bodies supporting the attachment plate.

5. The resin molding device according to any one of claims 1 to 4, **characterized in that**
the tip portion of the substrate pressing member has a tapered portion, and
the tip portion including the tapered portion blocks a hole provided at the predetermined region to prevent the fluid resin from entering the hole.

6. The resin molding device according to any one of claims 1 to 4, **characterized in that**
the tip portion of the substrate pressing member has a tip surface, and
the tip surface comes into close contact with the predetermined region of the substrate to prevent the fluid resin from entering the predetermined region.

7. The resin molding device according to any one of claims 1 to 6, **characterized in that**
the resin molding device comprises at least one molding module which has a mold closing mechanism for closing the upper mold and the lower mold, and a resin material supply module which supplies the resin material to the one molding module, and
the resin material supply module is attachable to and detachable from the one molding module, and the one molding module is attachable to and detachable from another molding module.

8. A resin molding method, comprising:
arranging a substrate having an electronic component mounted on a main surface thereof between an upper mold and a lower mold facing the upper mold;
supplying a resin material into a cavity constituted of a space surrounded by a frame member and a bottom surface member which are included at least in the lower mold;
moving up and down the frame member by a first drive mechanism; and
moving up and down the bottom surface member inside the frame member by a second drive mechanism,
**characterized in that**
the resin molding method comprises:
moving up a substrate pressing member provided in the frame member or the bottom surface member;
bringing a tip portion of the substrate pressing member into close contact with a predetermined region of the substrate and pressing the predetermined region;
moving up the frame member and thereby pressing a peripheral edge portion of the substrate by the frame member;
producing a fluid resin from the resin material within the cavity;
moving up the bottom surface member and immersing the electronic component in the fluid resin; and
curing the fluid resin to form a cured resin, and
the electronic component is sealed with the cured resin cured at a region other than the predetermined region in the main surface of the substrate.

9. The resin molding method according to claim 8, **characterized in that**, in the supplying the resin material, the tip portion of the substrate pressing member is located higher than an upper surface of the frame member.

10. The resin molding method according to claim 8, **characterized in that**, in the pressing, the substrate pressing member supported by an elastic body is used.

11. The resin molding method according to claim 8, **characterized in that**, in the pressing, one or a plurality of the substrate pressing members attached to an attachment plate supported by one or a plurality of elastic bodies are used.

12. The resin molding method according to any one of claims 8 to 11, **characterized in that**
the tip portion of the substrate pressing member has a tapered portion, and
in the pressing, the tip portion including the tapered portion is used to block a hole provided at the predetermined region to prevent the fluid resin from entering the hole.

13. The resin molding method according to any one of claims 8 to 11, **characterized in that**
the tip portion of the substrate pressing member has a tip surface, and
in the pressing, the tip surface is brought into close contact with the predetermined region to prevent the fluid resin from entering the predetermined region.

14. The resin molding method according to any one of claims 8 to 13, **characterized in that**
the resin molding method comprises preparing at least one molding module which has a mold closing mechanism for closing the upper mold and the lower mold, and preparing a resin material supply module which supplies the resin material to the one molding module, and
the resin material supply module is attachable to and detachable from the one molding module, and the one molding module is attachable to and detachable from another molding module.
